# EUROPEAN PATENT SPECIFICATION

(11) **EP 0 404 553 B1**
(45) Date of publication and mention of the grant of the patent: **13.12.1995**
(21) Application number: 90306762.7
(22) Date of filing: 20.06.1990
(51) Int. Cl.: H01L 27/108, H01L 21/8242

(54) **Semiconductor memory device**
Halbleiterspeicheranordnung
Dispositif semi-conducteur à mémoire

(30) Priority: 20.06.1989 JP 158028/89
(43) Date of publication of application: 27.12.1990
(73) Proprietor: SHARP KABUSHIKI KAISHA, Osaka 545 (JP)
(72) Inventor: Iguchi, Katsuji, Yamatokoriyama-shi, Nara-ken (JP); Kakimoto, Seizo, Nara-shi, Nara-ken (JP); Shinmura, Naoyuki, Tenri-shi, Nara-ken (JP)
(74) Representative: Brown, Kenneth Richard

(56) References cited:
- EP-A- 0 295 709
- EP-A- 0 317 199
- PATENT ABSTRACTS OF JAPAN, vol. 13, no. 295 (E-783)[3643], 7th July 1989;& JP-A-1 074 752
- PATENT ABSTRACTS OF JAPAN, vol. 11, no. 231 (E-527)[2678], 28th July 1987; & JP-A-62 048 062
- PATENT ABSTRACTS OF JAPAN, vol. 13, no. 292 (E-782)[3640], 6th July 1989;& JP-A-1 073 656

## Description

This invention relates to a semiconductor memory device comprising a plurality of memory cells in each of which one electrode of a capacitor is connected to a terminal of a transistor formed on a semiconductor substrate; see, for example, JP-A-1 074 752, EP-A-0 295 709, JP-A-6 248 062 and JP-A-1 073 656. The invention relates also to a method for making such a device. More specifically, the invention relates to memory cells for DRAM (dynamic random access memory) devices.

The storage capacity of DRAMs, one of the highly sophisticated high-density storage elements, has increased at a multiplication of 4 in three years, and it is suspected that the DRAMs would be designed to have a storage capacity increasing from 4M, 16M, 64M and so on with passage of time. In order to accomplish the fabrication of high-density RAMs, memory cells used in the DRAM as storage elements must have a size reduced. On the other hand, in order to obtain an immunity against soft error which would result from radiations and also to secure signals of sufficient S/N ratio, the charge storage capacitance of each memory cell must be of a value higher than a certain minimum value. Because of this, it is not possible to form a charge storage capacitor on a semiconductor surface in DRAMs having a storage capacity higher than 4M. Instead, it is a recent trend to fabricate a three-dimensional memory cell structure wherein the charge storage capacitor is formed in a hole or groove defined in a semiconductor substrate or over a MOS transistor formed on a surface of the semiconductor substrate.

The technique in which the charge storage capacitor is formed in the hole or groove defined in the semiconductor substrate, that is, inside a trench, is advantageous in that, since the charge storage capacitance can be increased depending on the depth of the trench, the memory cell can be reduced in size. However, this technique has a disadvantage in that it is not technically easy to form a relatively deep trench with good reproducibility.

On the other hand, a stacked memory cell wherein the charge storage capacitor is formed over the MOS transistor is relatively suited for production. However, since as compared with that of the memory cell utilizing the trench the stacked memory cell has a limited capacitance, the stacked memory cell cannot be suited for use in DRAMs where the latter are desired to have an increased storage capacity of from 16M towards 64M. This is because a reduction in cell size tends to result in an abrupt decrease of the charge storage capacitance since the polycrystalline silicon film forming charge storage electrodes in the stacked memory cell has a relatively small thickness, for example, about 0.3»m allowing most of the charges to be accumulated on surface areas of the electrodes.

In view of the foregoing, the present invention has been devised to provide a semiconductor memory device having stacked memory cells which can have a charge storage capacitance equal to or higher than the minimum value even when they are integrated in a high density so as to have a memory capacity of 16M, 64M or more.

Another important object of the present invention is to provide a method of making the semiconductor memory device of the type referred to above.

To this end, in one aspect, the present invention provides a semiconductor memory device which comprises a plurality of memory cells each comprising a transistor formed on a surface of a semiconductor substrate, and a capacitor formed on the semiconductor substrate and having first and second electrodes, said first electrode being connected to a terminal of the transistor, the first electrode of the capacitor comprising a principal portion of generally cubic configuration, a peripheral portion spaced from and surrounding a side wall of the principal portion, and a bottom portion connecting an end of the principal portion with an end of the peripheral portion, and the second electrode of the capacitor comprising respective portions confronting the principal portion, the inner and outer wall surfaces of the peripheral portion and the bottom portion, of the first electrode.

Preferably, the number of each of the peripheral portion and the bottom portion of said first electrode is plural.

In another aspect, the present invention provides a method of making a semiconductor memory device comprising a plurality of memory cells in each of which a first electrode, comprising a principal portion and a peripheral portion, of a capacitor is connected to a terminal of a transistor formed on a semiconductor substrate, the method comprising the steps of:
(i) forming an electroconductive layer as a material for the first electrode of said capacitor after said transistor has been formed on the surface of said semiconductor substrate;
(ii) forming a side wall of the principal portion of said first electrode by removing a portion of the electroconductive layer excluding a region thereof on which said principal portion is to be formed, while leaving a thin film portion outside said region;
(iii) forming a peripheral side wall made of material etchable selectively relative to the electroconductive layer and surrounding a periphery of said side wall of the principal portion in contact therewith;
(iv) forming the peripheral portion of said first electrode, made of electroconductive material resistant to a corrosive to be used for removing the peripheral side wall, which peripheral portion surrounds the peripheral side wall in contact therewith and has an end portion connected therethrough to the thin film portion;
(v) removing a part of the thin film portion on a region outside the peripheral portion;
(vi) removing the peripheral side wall by the use of said corrosive; and
(vii) forming sequentially over the first electrode an insulating layer and a second electrode of the capacitor.

Preferably, the steps (iii) and (iv) are repeated before performing the subsequent steps.

According to one embodiment, said principal portion is formed with a generally cubic configuration.

According to another embodiment, said principal portion is formed with a generally cup-shaped configuration.

According to the present invention, since the first electrode of the capacitor comprises the principal portion, the peripheral portion and the bottom portion connected together while the second electrode of the same capacitor comprises respective portions confronting the principal portion, the peripheral portion and the bottom portion of the first electrode, the area of surface of the first and second electrodes which confront each other increases enough to permit the charge storage capacitance to increase as compared with the case in which the first electrode comprises only the principal portion. Moreover, according to the method of the present invention, since the peripheral portion of the first electrode is formed so as to surround the side wall of a principal portion of either generally rectangular cubic configuration or generally cup-shaped configuration, and the second electrode is formed so as to confront both the inner and outer wall surfaces of the peripheral portion,the total area of surface of the first and second electrodes which confront each other can be increased with no need to increase the area of surface of the bottom of this electrode. Accordingly, the charge storage capacitance higher than the minimum value can be secured when a high density integration is desired to be achieved.

Where the number of each of the peripheral portion and the bottom portion of said first electrode is plural, an advantage can be appreciated in that the charge storage capacitance can be further increased for a given surface area of the first electrode.

Also, since the peripheral side wall surrounding and held in contact with the side wall of the principal portion of the first electrode and the peripheral portion surrounding and held in contact with this peripheral side wall are formed in a self-aligned fashion without employing the lithographic technique, the distance between each of the neighbouring capacitors in the memory cell can be set to a value smaller than the minimum distance achieved by the lithographic technique. Accordingly, the cell surface area can be effectively utilized to secure the charge storage capacitance higher than the minimum value when a high density integration is desired to be achieved.

The repetition of the steps of forming the peripheral portion and the bottom portion, respectively, can result in the formation of a large capacitance capacitor without the number of masks being increased.

The present invention will become clear from the following detailed description of preferred embodiments thereof with reference to the accompanying drawings, in which:
Fig. 1 is a schematic perspective view of an essential portion of a semiconductor memory device according to a preferred embodiment of the present invention;
Figs. 2(A-1), 2(B-1), 2(C-1), 2(D-1), 2(E-1) and 2(F-1) are top plan views of the semiconductor memory device, showing the sequence of manufacture thereof at different process steps, respectively according to a first preferred method of the present invention;

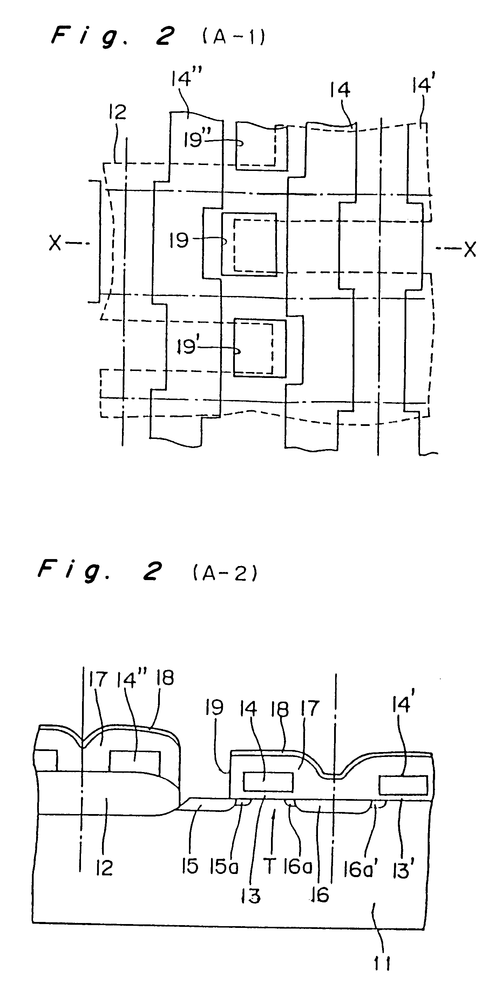

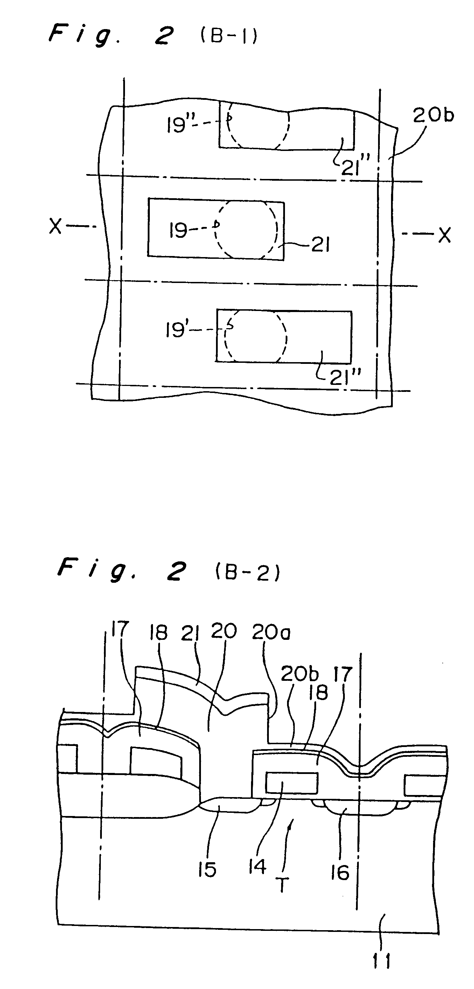

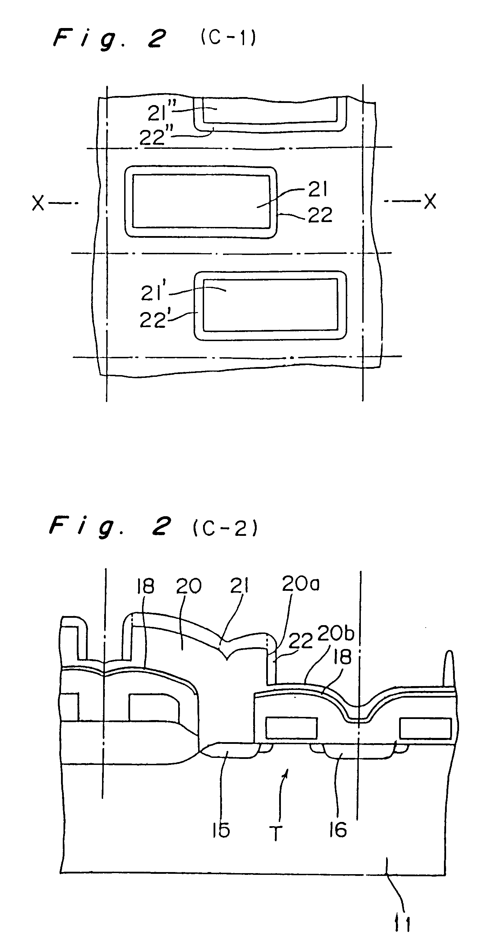

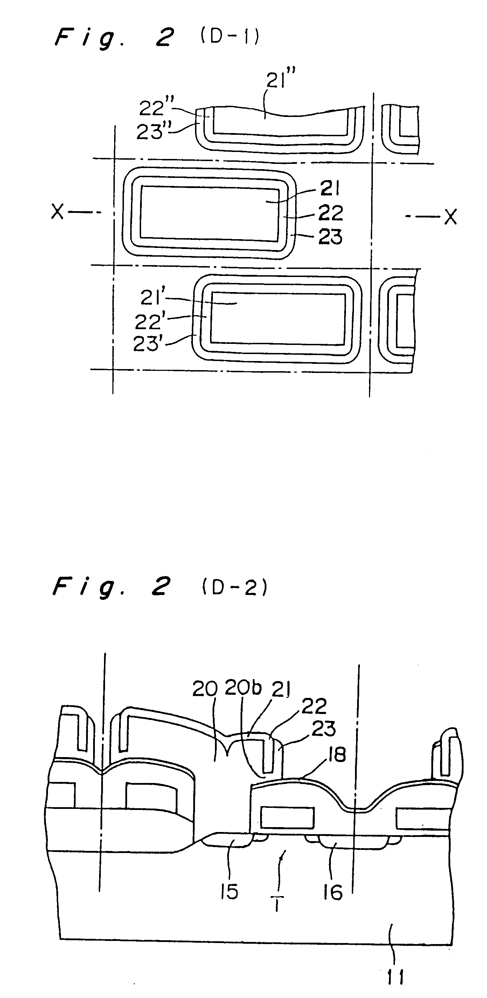

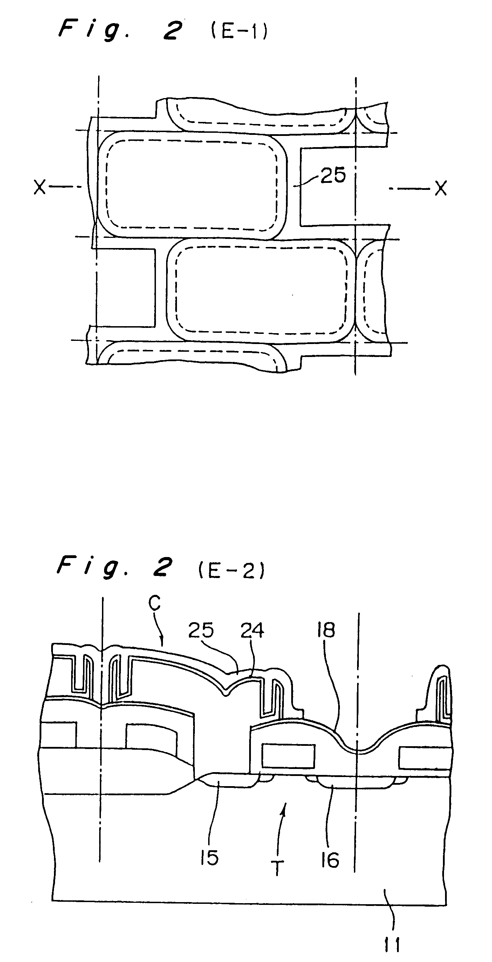

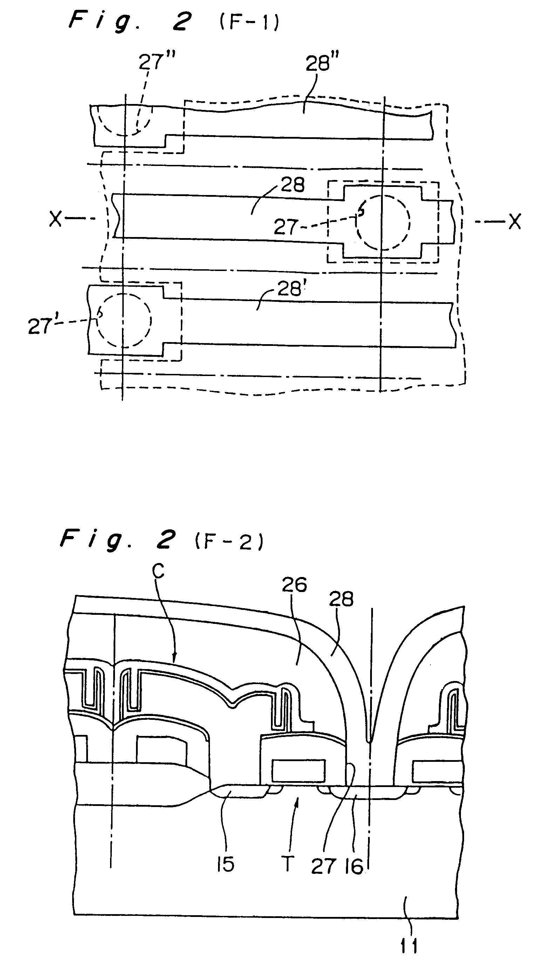

Figs. 2(A-2), 2(B-2), 2(C-2), 2(D-2), 2(E-2) and 2(F-2) are cross-sectional views taken along the lines X-X in Figs. 2(A-1), 2(B-1), 2(C-1), 2(D-1), 2(E-1) and 2(F-1), respectively;

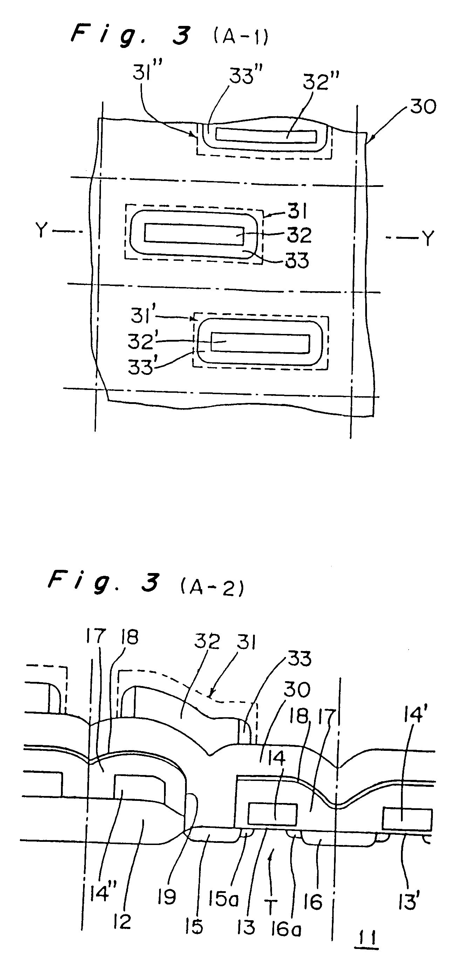

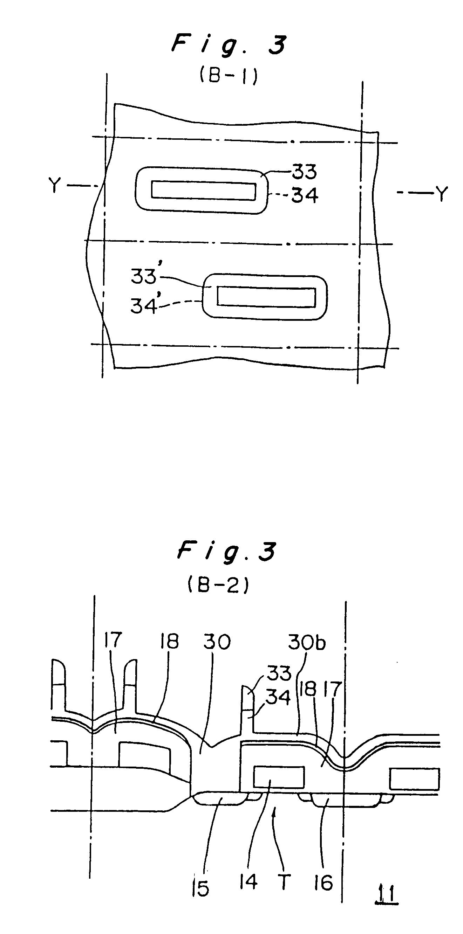

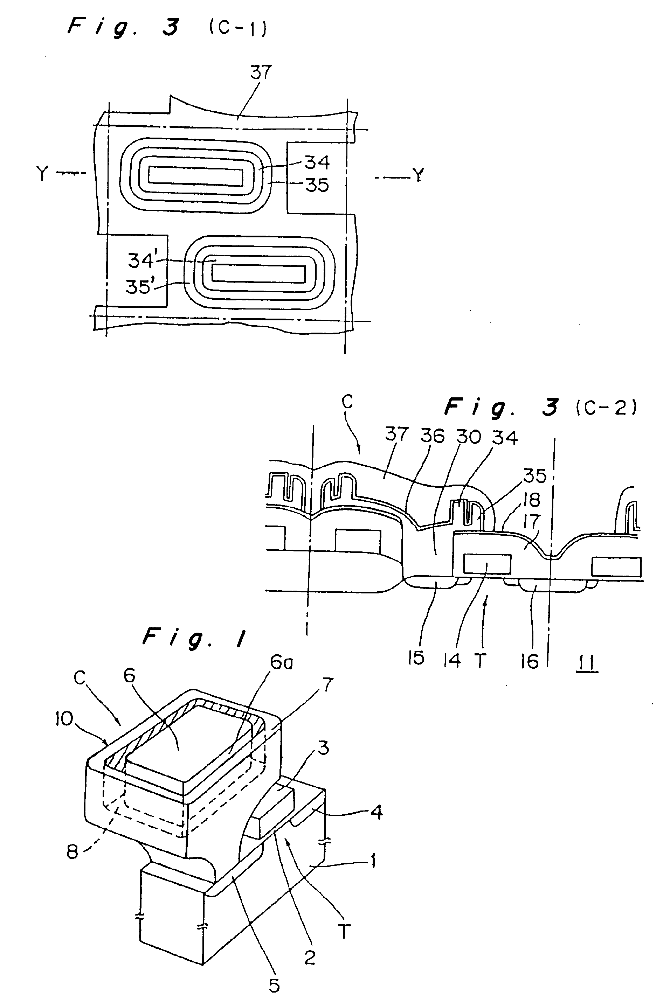

Figs. 3(A-1), 3(B-1) and 3(C-1) are top plan views of a semiconductor memory device, showing the sequence of manufacture thereof at different process steps according to a second preferred method of the present invention; and
Figs. 3(A-2), 3(B-2) and 3(C-2) are cross-sectional views taken along the lines Y-Y in Figs. 3(A-1), 3(B-1) and 3(C-1), respectively.

Referring first to Fig. 1 showing a semiconductor memory element according to a preferred embodiment of the present invention, the semiconductor memory element shown therein is of a so-called stacked structure and comprises a transistor T formed on a surface of a semiconductor substrate 1 and a capacitor C positioned above the transistor T. The transistor T includes a source region 5, a drain region 4, a gate insulating layer 2 and a gate electrode 3 formed on the gate insulating layer 2. The capacitor C includes a first or lower electrode 10 connected with the source region 5 of the transistor T, a second or upper electrode (not shown), and an insulating layer (not shown) positioned between the first or lower and second or upper electrodes.

The first electrode 10 comprises a principal portion 6 of a generally rectangular cubic configuration having a peripheral side wall 6a, a peripheral portion 7 spaced a distance from and surrounding the peripheral side wall 6a of the principal portion 6, and a bottom portion 8 integrating an end of the principal portion 6 and an end of the peripheral portion 7. On the other hand, the second electrode comprises respective portions confronting the principal portion 6, the peripheral portion 7 and the bottom portion 8, respectively.

The semiconductor memory element of the above described construction is manufactured by a process according to a first preferred method of the present invention which will now be described with reference to Fig. 2 which is composed of Figs. 2(A-1), 2(A-2), 2(B-1), 2(B-2), 2(C-1), 2(C-2), 2(D-1), 2(D-2) , 2(E-1) 2(E-2), 2(F-1) and 2(F-2). It is, however, to be noted that Figs. 2(A-1), 2(B-1), 2(C-1), 2(D-1), 2(E-1) and 2(F-1) are top plan views of the semiconductor memory device, respectively, whereas Figs. 2(A-2), 2(B-2), 2(C-2), 2(D-2), 2(E-2) and 2(F-2) are cross-sectional views taken along the lines X-X in Figs. 2(A-1), 2(B-1), 2(C-1), 2(D-1), 2(E-1) and 2(F-1), respectively. It is also to be noted that a pair of parallel single-dotted phantom lines employed in each of these figures forming Fig. 2 represent a region of the semiconductor memory device which is occupied by a single memory cell comprising of the previously mentioned transistor T and capacitor C. In describing the method of making the semiconductor memory device according to the present invention, reference will be made only to the fabrication of the single memory cell and, therefore, those parts of adjacent memory cells which function similarly to those parts of the memory cell discussed hereinafter and which are formed on respective sides of the memory cell discussed hereinafter in substantially symmetrical relation will be identified with like reference numerals to which a single prime (′) and a double prime (˝) are respectively affixed.

Also, for facilitating a better understanding of the present invention, the method steps will be described individually under separate headings.

### Method Step 1 - Figs. 2(A-1) and 2(A-2):

In a manner well known to those skilled in the art, the transistor T is formed on a surface of a P-type silicon substrate 11, followed by the formation, as interlayer insulating layers, of a SiO₂ layer 17 and a Si₃N₄ layer 18. Respective portions of the SiO₂ and Si₃N₄ layers 17 and 18 aligned with a source region 15 of the transistor T are subsequently removed to define a contact hole 19. A region 12 specifically shown by the phantom line in Fig. 2(A-1) represents a cell separating area formed of SiO₂ by the use of a selective oxidization process. Reference numerals 13 and 13′ represent gate insulating layers each formed of SiO₂ by the use of a thermal oxidization process; reference numerals 14, 14′ and 14˝ represent gate electrodes (word lines) each formed of phosphor-doped polycrystalline silicon; reference numerals 15 and 16 represent the source region of N⁺-type and a drain region of N⁺-type, respectively, each of said regions being formed by injecting arsenic ions into the substrate 11; and reference numerals 15a, 16a and 16a′ represent respective N⁻ regions formed by injecting phosphor ions into the substrate 11 and having a LDD (light doped drain) structure.

It is to be noted that the Si₃N₄ layer 18 is formed for the purpose of protecting the SiO₂ layer 17, positioned beneath the Si₃N₄ layer 18, from a subsequently performed hydrochlorination (as will be described under the heading of Method Step 5) and has a sufficient film thickness selected in consideration of a possible reduction in film thickness which would occur as a result of the layer being somewhat etched off at the time of etching of the polycrystalline silicon during the execution of the Method Step 4 as will be described later.

### Method Step 2 - Figs. 2(B-1) and 2(B-2):

As material for the first electrode 10 of the capacitor C, a phosphor-doped polycrystalline silicon layer 20 of relatively great film thickness as material for the first electrode 10 of the capacitor C and a SiO₂ layer 21 as a masking material used during the etching of the phosphor-doped polycrystalline silicon layer 20 are formed over the entire surface of the assembly. Then, using, as a mask, a resist layer formed by the use of a lithographic technique, the SiO₂ layer 21 is processed by means of a reactive ion etching process to define the generally rectangular electrode. After the removal of the resist layer, the SiO₂ layer 21 so processed as hereinabove described is used as a mask with which the polycrystalline silicon layer 20 having a relatively great film thickness is etched off leaving a thin film portion 20b. A thick film portion of the polycrystalline silicon layer 20 corresponds to the principal portion 6 of the first electrode 10 shown in and described with reference to Fig. 1. It is to be noted that, where a semiconductor memory element described and disclosed in the Japanese Patent Application No. 63-227945, filed September 12, 1988, in the name of the same assignee of the present invention is to be fabricated, that portion of the polycrystalline silicon layer 20 which is positioned above a region from which the SiO₂ layer 21 has been removed is completely removed so that the first electrode 10 can be constituted only by the principal portion 6.

### Method Step 3 - Figs. 2(C-1) and 2(C-2):

By the use of a reduced pressure gas growth (LPCVD) method, a SiO₂ layer capable of exhibiting a good coverage of steps is formed over the entire surface of the assembly and, subsequently, a flat portion of the SiO₂ layer so formed, except for a different portion (steps) thereof corresponding to a side wall 20a of the polycrystalline silicon layer 20, is removed by the use of a reactive ion etching process. In this way, as shown in Figs. 2(C-1) and 2(C-2), a peripheral side wall 22 comprising of the SiO₂ layer is formed on the side wall 20a of the polycrystalline silicon layer 20. It is to be noted that a reduced pressure CVD process is employed for the purpose of making it possible to form the SiO₂ layer of sufficient film thickness on the side walls 20a of the polycrystalline silicon layer 20 and, also, the reactive ion etching process is employed for avoiding the peripheral side wall 22 from being etched off. It is also to be noted that, as material for the peripheral side wall 22, any material capable of being etched off selectively relative to the polycrystalline Si 20 can be employed in place of the SiO₂.

### Method Step 4 - Figs. 2(D-1) and 2(D-2):

After the formation of the polycrystalline silicon layer over the entire surface, both of the polycrystalline silicon layer and the thin film portion 20b of the polycrystalline silicon layer 20 are completely etched off except for respective portions thereof corresponding to the step. In this way, as shown in Figs. 2(D-1) and 2(D-2), a generally ring-shaped polycrystalline silicon 23 formed of polycrystalline silicon and externally surrounding the peripheral side wall 22 with a bottom thereof contiguous with the thin film portion 20b is formed. This polycrystalline silicon 23 corresponds to the peripheral portion 7 of the first electrode 10 shown in and described with reference to Fig. 1. At the same time, a portion of the thin film portion 20b corresponding to an outer region of the polycrystalline silicon 23 is removed to form the bottom portion 8 of the first electrode 10. The thick film portion of the polycrystalline silicon layer 20 is then electrically connected with the generally ring-shaped polycrystalline silicon 23 through the thin film portion 20b. It is to be noted that, although material for the peripheral portion 7 of the first electrode 10 has been the same as that for the principal portion 6, that is, the polycrystalline silicon, it may not be limited thereto and an electroconductive material of a type which will not be attacked by a corrosive used to remove the peripheral wall 22 during the method step 5 as will be described later may be employed for peripheral portion 7 of the first electrode 10. Also, it is preferred that the polycrystalline silicon layer 20b is etched selectively relative to the Si₃N₄ layer 18 when the former is to be etched.

### Method Step 5 - Figs. 2(E-1) and 2(E-2):

Thereafter, as shown in Figs. 2(E-1) and 2(E-2), the SiO₂ layer 21 and the peripheral side wall 22 formed of a SiO₂ film are removed by the use of an etching solution containing hydrofluoric acid (HF). Subsequently, a capacitor insulating layer 24 of the capacitor C is formed and a plate electrode 25 which may eventually form a wiring common to all of the memory cells is formed as one electrode of the capacitor C. The capacitor insulating layer 24 is in the form of a SiO₂/Si₃N₄ double-layered film obtained by forming a Si₃N₄ layer by the use of the LPCVD process and then oxidizing a surface of the Si₃N₄ layer by means of a wet oxidization. Also, the plate electrode 25 is made of phosphor-doped polycrystalline silicon.

### Method Step 6 - Figs. 2(F-1) and 2(F-2):

Finally, as shown in Figs. 2(F-1) and 2(F-2), after the formation of an interlayer insulating film 26, a contact hole 27 is opened above the drain region 16 of the transistor T, followed by the formation of a common wiring (bit line) 28, thereby completing the manufacture of the semiconductor memory element shown in Fig. 1.

Where the semiconductor memory element of the construction described hereinbefore is manufactured at a minimum line width of 0.5»m, the memory cell size will be 3»m x 1.2»m = 3.6»m². If the thickness of the polycrystalline silicon electrode 20 is 0.5»m and the size of the SiO₂ mask 21 is 0.6»m x 1.35»m, the area of surfaces of the polycrystalline silicon electrode calculated from this size will be 2.8»m² In such case, the prior art stacked memory cell would utilize a surface area of about 3»m² for the capacitor. However, in the semiconductor memory element according to the present invention, where the peripheral portion 7 formed of the polycrystalline silicon film of 0.1»m in thickness is connected by forming the peripheral side wall of SiO₂ of 0.1»m in film thickness on the principal portion 6, the surface area of about 7.6»m² can be utilized for the capacitor. Indeed, a comparative measurement of the capacitance of the capacitor per memory cell has indicated that, while that in the prior art stacked memory cell was 17fF, the capacitance of the capacitor per memory cell in the memory device of the construction described hereinbefore according to the present invention was 42fF and, therefore, it can be effectively utilized in the DRAM of 16M. Neither the leak current nor a considerable deterioration in lifetime of the capacitor insulating film was found.

Thus, the provision of the peripheral portion 7 surrounding the side wall 6a of the principal portion 6 of generally cubic configuration which forms the first electrode 10, makes it possible to increase the area of surface confronting the capacitor C without unnecessarily increasing the area of bottom surface of the first electrode 10. Also, since both of the peripheral side wall 22 and the peripheral portion 23 are provided in self-aligned fashion without employing any lithographic technique, the distance between each of the neighbouring capacitors C in the semiconductor memory device can be reduced to a value smaller than the limit imposed by the lithographic technique and, therefore, the elements can be integrated in a high density. Moreover, no need arises to increase the number of the masks.

Although in the foregoing embodiment the peripheral portion 7 of the first electrode has been described as of a generally ring-shape, it may be formed in a shape similar to two or more coaxial rings. By way of example, a process from the method step 3 to the method step 4 (corresponding to Figs. 2(C-1) and 2(C-2) and Figs. 2(D-1) and 2(D-2), respectively) may be repeated twice to form the peripheral portion 7 of a shape similar to the two coaxial rings.

More specifically, during the execution of the method step 4, the thin film 20b of polycrystalline silicon is allowed to remain when the first ring of polycrystalline silicon 23 is to be formed by the use of the reactive ion etching process. Then, the method step 3 is executed to form the peripheral side wall in the form of a SiO₂ film, followed by the formation of a second ring of the peripheral portion of polycrystalline silicon which is positioned externally of the first ring of polycrystalline silicon. Where the peripheral portion 7 is fabricated in the form of the double coaxial rings as described above, the number of method steps increases. However, the number of masks is not increased. In any event, the capacitor of high capacitance for a cell size can be fabricated.

According to a second preferred method of the present invention, the principal portion 6 of the first electrode 10 is so shaped as to assume a cup-like configuration. The semiconductor memory element having the principal portion of a generally cup-like configuration produced according to the second preferred method of the present invention will now be described with reference to Fig. 3 composed of Figs. 3(A-1), 3(A-2), 3(B-1), 3(B-2), 3(C-1) and 3(C-2). It is, however, to be noted that in describing the second preferred method of the present invention only differences of the second preferred method of the present invention from the first preferred method of the present invention will be described for the sake of brevity.

### Method Step 11 - Figs. 3(A-1) and 3(A-2):

As shown in Figs. 3(A-1) and 3(A-2), by performing the method step 1 described with reference to Figs. 2(A-1) and 2(A-2), the contact hole 19 is first formed, followed by the formation of a phosphor-doped polycrystalline silicon layer 30 of relatively large thickness as a material for the first electrode of the capacitor and then followed by the formation of a PSG layer 31. The PSG layer 31 is processed using as a mask a resist formed by the use of a lithographic technique and is then etched somewhat by the use of an etching solution containing hydrofluoric acid (HF) to provide a generally shrunk PSG layer 32. Then, after a SiO₂ layer has been deposited over the entire surface by the use of the LPCVD process, a portion of the SiO₂ corresponding to a flat portion is removed by the use of the reactive ion etching process to allow a portion 33 of the SiO₂ to remain on a side wall of the PSG layer 32.

### Method Step 12 - Figs. 3(B-1) and 3(B-2):

Then, using an etching solution containing hydrofluoric acid (HF), the PSG layer 32 is removed. The SiO₂ layer portion 33 left remaining on the side wall remains unremoved as shown in Figs. 3(B-1) and 3(B-2) because the etching rate is low as compared with the PSG layer 32. Thereafter, the SiO₂ layer portion 33 on the side wall is left as a mask, followed by the etching of the polycrystalline silicon layer 30 of thick film with the use of the reactive ion etching process. This etching is interrupted while a thin film portion 30b of the polycrystalline silicon layer 30 is left unremoved. In this way, a generally cup-shaped electrode 34 can be formed as the principal portion of the first electrode of the capacitor C.

### Method Step 13:

The method steps subsequent to the method step 12 are substantially identical with those described in connection with the first preferred method of the present invention, and a generally ring-shaped peripheral portion 35 and a bottom portion 30b are formed externally adjacent the cup-shaped electrode 34, followed by the formation of a plate electrode 37 after the formation of a capacitor insulating layer 36.

With the semiconductor memory element manufactured in the above described manner it has been found that the capacitance per cell when the peripheral portion 35 is provided is 38fF whereas the capacitance per cell when no peripheral portion is provided is 18fF. Thus, as is the case with the preferred embodiment of the present invention, the capacitance is increased for a given cell size. The above mentioned data on the capacitance were obtained when the polycrystalline silicon layer 30 is 0.4»m in film thickness and the same conditions as in the first preferred method of the present invention were employed.

According to the device of the invention, a capacitor of high capacitance hitherto achieved in the prior art stacked memory cell can be realized and, even when a DRAM of 16M or higher capacity is to be fabricated in a high density, a charge storage capacitance higher than the minimum value can be secured.

According to the method of the invention, without any need to increase the number of masks, the peripheral portion can be provided in self-aligned fashion with the principal portion and, therefore, the distance between each of the neighbouring capacitors of the memory cells can be minimized to a value smaller than the limitation imposed by the lithographic technique, enabling a high density integration of elements.

While in any one of the foregoing embodiments of the present invention reference has been made to a cell structure of so-called folded-bit-line system, the present invention is equally applicable to the cell structure of open-bit-line system. Also, while N-channel MOS transistors have been formed on the P-type silicon substrate to provide memory cell transistors, they may be formed in a P-type region on an N-type silicon substrate or P-channel MOS transistors may be formed on an N-type silicon substrate or an N-type region on a P-type silicon substrate to provide the memory cell transistors.

Also, with respect to the shape of the element separating region, the detailed structure thereof and the method of forming it, material for the electrode of each capacitor, the structure thereof and the method of forming the capacitors, and material for the capacitor insulating layer, the structure thereof and the method of forming the capacitor insulating layer, the present invention should not be limited to those disclosed herein in connection with any one of the preferred embodiments thereof, except as defined by the claims.

## Claims

1. A semiconductor memory device which comprises a plurality of memory cells, each of said memory cells comprising:
a transistor (T) formed on a surface of a semiconductor substrate (1); and
a capacitor (C) formed on the semiconductor substrate and having first (10) and second (25) electrodes, said first electrode being connected to a terminal (5) of the transistor;
said first electrode (10) of the capacitor comprising a principal portion (6;34) of generally cubic configuration, a peripheral portion (7;23;35) spaced from and surrounding a side wall (6a;20a) of the principal portion, and a bottom portion (8;20b;30b) connecting an end of the principal portion with an end of the peripheral portion; and
said second electrode (25;37) of the capacitor comprising respective portions confronting the principal portion, the inner and outer wall surfaces of the peripheral portion and the bottom portion, of the first electrode.

2. The device as claimed in claim 1, wherein the number of each of the peripheral portion and the bottom portion of said first electrode is plural.

3. A method of making a semiconductor memory device comprising a plurality of memory cells in each of which a first electrode (10), comprising a principal portion (6;34) and a peripheral portion (7;35), of a capacitor (C) is connected to a terminal (5) of a transistor (T) formed on a semiconductor substrate (1), the method comprising the steps of:
(i) forming an electroconductive layer (20;30) as a material for the first electrode (10) of said capacitor after said transistor has been formed on the surface of said semiconductor substrate;
(ii) forming a side wall (6a;20a) of the principal portion (6;34) of said first electrode by removing a portion of the electroconductive layer excluding a region thereof on which said principal portion is to be formed, while leaving a thin film portion (20b;30b) outside said region;
(iii) forming a peripheral side wall (22) made of material etchable selectively relative to the electroconductive layer and surrounding a periphery of said side wall of the principal portion in contact therewith;
(iv) forming the peripheral portion (7;23;35) of said first electrode, made of electroconductive material resistant to a corrosive to be used for removing the peripheral side wall, which peripheral portion surrounds the peripheral side wall (22) in contact therewith and has an end portion connected therethrough to the thin film portion (20b;30b);
(v) removing a part of the thin film portion on a region outside the peripheral portion;
(vi) removing the peripheral side wall (22) by the use of said corrosive; and
(vii) forming sequentially over the first electrode an insulating layer (24;36) and a second electrode (25;37) of the capacitor.

4. The method as claimed in claim 3, wherein the steps (iii) and (iv) are repeated before the subsequent steps are performed.

5. The method as claimed in claim 3 or claim 4, wherein said principal portion (20) is formed with a generally cubic configuration.

6. The method as claimed in claim 3 or claim 4, wherein said principal portion (34) is formed with a generally cup-shaped configuration.

## Patentansprüche

1. Halbleiterspeicher-Bauteil, das mehrere Speicherzellen enthält, von denen jede folgendes aufweist:
- einen an der Oberfläche eines Halbleitersubstrats (1) ausgebildeten Transistor (T) und
- einen auf dem Halbleitersubstrat ausgebildeten Kondensator (C) mit einer ersten (10) und einer zweiten (25) Elektrode, wobei die erste Elektrode mit einem Anschluß (5) des Transistors verbunden ist;
- wobei die erste Elektrode (10) des Kondensators einen Hauptabschnitt (6; 34) mit im wesentlichen würfelförmiger Konfiguration, einen Umfangsabschnitt (7; 23; 35), der von der Seitenwand (6a; 20a) des Hauptabschnitts beabstandet ist und diese umgibt, und einen Bodenabschnitt (8; 20b; 30b) aufweist, der ein Ende des Hauptabschnitts mit einem Ende des Umfangsabschnitts verbindet; und
- wobei die zweite Elektrode (25; 37) des Kondensators jeweilige Abschnitte enthält, die dem Hauptabschnitt, den Innen- und Außenwandflächen des Umfangsabschnitts und dem Bodenabschnitt der ersten Elektrode gegenüberstehen.

2. Bauteil nach Anspruch 1, bei dem sowohl der Umfangsabschnitt als auch der Bodenabschnitt der ersten Elektrode jeweils mehrfach vorliegen.

3. Verfahren zum Herstellen eines Halbleiterspeicher-Bauteils mit mehreren Speicherzellen, in denen jeweils eine erste Elektrode (10), mit einem Hauptabschnitt (6; 34) und einem Umfangsabschnitt (7; 35), eines Kondensators (10) mit einem Anschluß (5) eines auf einem Halbleitersubstrat (1) ausgebildeten Transistors (T) verbunden ist, wobei das Verfahren folgende Schritte aufweist:
(i) Herstellen einer elektrisch leitenden Schicht (20; 30) als Material für die erste Elektrode (10) des Kondensators, nachdem der Transistor auf der Oberfläche des Halbleitersubstrats ausgebildet wurde;
(ii) Herstellen einer Seitenwand (6a; 20a) des Hauptabschnitts (6; 34) der ersten Elektrode durch Entfernen eines Abschnitts der elektrisch leitenden Schicht mit Ausnahme eines Bereichs derselben, auf dem der Hauptabschnitt auszubilden ist, während ein dünner Filmabschnitt (20b; 30b) außerhalb des Bereichs zurückgelassen wird;
(iii) Herstellen einer Umfangsseitenwand (22) aus einem Material, das selektiv in bezug auf die elektrisch leitende Schicht ätzbar ist und den Umfang der Seitenwand des Hauptabschnitts umgibt, der in Kontakt mit ihr steht,
(iv) Herstellen des Umfangsabschnitts (7; 23; 35) der ersten Elektrode aus einem elektrisch leitenden Material, das gegen ein korrodierendes Mittel beständig ist, wie es zum Entfernen der Umfangsseitenwand zu verwenden ist, wobei der Umfangsabschnitt die Umfangsseitenwand (22) umgibt und in Kontakt mit ihr steht und einen Endabschnitt aufweist, der über sie mit dem dünnen Filmabschnitt (20b; 30b) verbunden ist;
(v) Entfernen eines Teils des dünnen Filmabschnitts auf einem Bereich außerhalb des Umfangsabschnitts;
(vi) Entfernen der Umfangsseitenwand (22) unter Verwendung des korrodierenden Mittels und
(vii) Herstellen einer Isolierschicht (24; 36) und einer zweiten Elektrode (35; 37) des Kondensators der Reihe nach über der ersten Elektrode.

4. Verfahren nach Anspruch 3, bei dem die Schritte (iii) und (iv) wiederholt werden, bevor die folgenden Schritte ausgeführt werden.

5. Verfahren nach Anspruch 3 oder Anspruch 4, bei dem der Hauptabschnitt (20) mit im wesentlichen würfelförmiger Konfiguration hergestellt wird.

6. Verfahren nach Anspruch 3 oder Anspruch 4, bei dem der Hauptabschnitt (34) mit im wesentlichen tassenförmiger Konfiguration hergestellt wird.

## Revendications

1. Dispositif de mémoire à semi-conducteur qui comprend une multiplicité de cellules de mémoire, chacune desdites cellules de mémoire comprenant:
un transistor (T) formé sur une surface d'un substrat en semi-conducteur (1); et
un condensateur (C) formé sur le substrat en semiconducteur et comportant des première (10) et seconde (25) électrodes, ladite première électrode étant reliée à une borne (5) du transistor;
ladite première électrode (10) du condensateur comportant une partie principale (6; 34) de configuration générale cubique, une partie périphérique (7; 23; 35) espacée d'une paroi latérale (6a; 20a) de la partie principale et entourant cette paroi, et une partie de fond (8; 20b; 30b) reliant une extrémité de la partie principale à une extrémité de la partie périphérique; et
ladite seconde électrode (25; 37) du condensateur comprenant des parties respectives opposées à la partie principale, aux surfaces de parois intérieure et extérieure de la partie périphérique et à la partie de fond, de la première électrode.

2. Dispositif selon la revendication 1, dans lequel il existe plus d'un de chacun des éléments suivants: la partie périphérique et la partie de fond de ladite première électrode.

3. Procédé de fabrication d'un dispositif de mémoire à semi-conducteur comprenant une multiplicité de mémoires de cellule dans chacune desquelles une première électrode (10), comprenant une partie principale (6; 34) et une partie périphérique (7; 35), d'un condensateur C est reliée à une borne (5) d'un transistor (T) formé sur un substrat en semiconducteur (1), le procédé comprenant les étapes consistant:
(i) à former une couche électro-conductrice (20; 30), constituant un matériau pour la première électrode (10) dudit condensateur, après la formation dudit transistor sur la surface dudit substrat en semi-conducteur;
(ii) à former une paroi latérale (6a; 20a) de la partie principale (6; 34) de ladite première électrode en éliminant une partie de la couche électro-conductrice à l'exclusion d'une région de celle-ci sur laquelle ladite partie principale doit être formée, tout en conservant une partie de film mince (20b; 30b) à l'extérieur de ladite région;
(iii) à former une paroi latérale périphérique (22) en un matériau pouvant être attaqué chimiquement de façon sélective par rapport à la couche électro-conductrice et entourant une périphérie de ladite paroi latérale de la partie principale en contact avec elle;
(iv) à former la partie périphérique (7; 23; 35) de ladite première électrode, réalisée en un matériau électro-conducteur résistant à un agent corrosif devant être utilisé pour éliminer la paroi latérale périphérique, cette partie périphérique entourant la paroi latérale périphérique (22) en contact avec elle et comportant une partie d'extrémité reliée par son intermédiaire à la partie de film mince (20b; 30b);
(v) à éliminer partiellement la partie de film mince sur une région située à l'extérieur de la partie périphérique;
(vi) à éliminer la paroi latérale périphérique (22) à l'aide dudit agent corrosif; et
(vii) à former séquentiellement, sur la première électrode, une couche isolante (24; 36) et une seconde électrode (25; 37) du condensateur.

4. Procédé selon la revendication 3, dans lequel les étapes (iii) et (iv) sont répétées avant l'exécution des étapes subséquentes.

5. Procédé selon la revendication 3 ou la revendication 4, dans lequel ladite partie principale 20 est réalisée de façon à présenter une forme générale cubique.

6. Procédé selon la revendication 3 ou la revendication 4, dans lequel ladite partie principale (34) est formée de façon à présenter la forme générale d'une coupelle.
